# EUROPÄISCHE PATENTSCHRIFT

(11) **EP 0 734 062 B1**
(45) Veröffentlichungstag und Bekanntmachung des Hinweises auf die Patenterteilung: **26.09.2001**
(21) Anmeldenummer: 96810159.2
(22) Anmeldetag: 14.03.1996
(51) Int. Cl.: H01L 23/367, H01L 21/48, H01L 23/467

(54) **Kühlkörper für Halbleiterbauelemente od. dgl.**
Heat sink for semiconductor device or similar
Dissipateur de chaleur pour dispositif semi-conducteur ou similaire

(30) Priorität: 24.03.1995 DE 29505000 U
(43) Veröffentlichungstag der Anmeldung: 25.09.1996
(73) Patentinhaber: Alusuisse Technology & Management AG, 8212 Neuhausen am Rheinfall (CH)
(72) Erfinder: Bock, Uwe, 78224 Singen (DE)

(56) Entgegenhaltungen:
- EP-A- 0 483 058
- EP-A- 0 485 205
- DE-A- 2 502 472
- DE-A- 4 314 663

## Beschreibung

Die Erfindung betrifft eine Hochleistungskühleinheit für Halbleiterbauelemente od. dergl. Geräte mit einem Kühlkörper, insbesondere aus stranggepresstem Aluminium oder anderem Leichtmetall, mit in Abstand zueinander an eine Grundplatte angeschlossenen und davon aufragenden Kühlrippen, die jeweils als Hohlprofil mit zwei zueinander parallelen Rippenwänden und diese verbindenden Querstegen ausgebildet sind, wobei durch die Rippenwände zwischen zwei benachbarten Querstegen jeweils ein Strömungskanal gebildet wird, und die Kühlrippen einen Kupplungssockel aufweisen und die Kühlrippen mit ihrem Kupplungssockel in von Bodenrippen flankierten Einsatznuten od. dergl. Ausnehmungen der Grundplatte festliegen.

Die DE-PS 35 18 310 beschreibt stranggepreßte Vollprofile mit seitlichen Ausformungen als Kühlrippen, die in Einsatznuten der Grundplatte formschlüssig eingesetzt werden. Zudem erwähnt diese Druckschrift sog. Rippenverhältnisse (Verhältnis der Höhe zum lichten Abstand) von mehr als 12 : 1, womit die Grenze der erreichbaren Oberfläche bestimmt ist. Sowohl technische als auch wirtschaftliche Gesichtspunkte erfordern je nach Rippenhöhe eine Mindestrippendicke. Die Fertigung eines Kühlkörpers mit dünnen Rippen bei hoher Rippenzahl geht wegen des größeren Aufwandes zu Lasten der Wirtschaftlichkeit.

Gegenüber der Lehre der DE-PS 35 18 310 stellt eine gattungsgemäßen Kühlkörper mit zwischen zwei -- mit der Grundplatte eine Art Rechteckrinne ergebenden -Flankenwänden verlaufenden Kühlrippen nach der EP-A-0 483 058 der Anmelderin eine Verbesserung dar. Sowohl die Innenflächen der Flankenwände als auch die Außenflächen der Kühlrippen sind mit Riffelungen ausgestattet, die parallel zur Grundplatte verlaufen. Die beiden Rippenwände jeder Kühlrippe sind an einem Ende durch einen in der Einsatznut der Grundplatte festlegbaren Kupplungssockel und am anderen Ende durch einen Quersteg verbunden; ein weiterer Quersteg teilt den Rippenhohlraum etwa in halber Höhe in zwei Kanäle. Mit diesem Kühlkörper sollten sowohl die Wanddicken von Kühlrippen als auch der Herstellungsaufwand für den Kühlkörper vermindert werden. Es wurde ein Rippenverhältnis von etwa 30 : 1 erreicht.

Besonders bei Zwangsbelüftung mit Axiallüftern ergeben sich Bauformen relativ großer Rippenhöhe und geringer Rippendicke. Der Rippenwirkungsgrad ist damit relativ schlecht. Verfahrensbedingt ist der Abstand zwischen den einzelnen Kühlrippen mit mindestens 3 mm nach unten begrenzt.

In Kenntnis dieses Standes der Technik hat sich der Erfinder die Aufgabe gestellt, die Kühlleistung je Volumeneinheit weitergehend zu verbessern. Dazu ist es erforderlich, den Rippenwirkungsgrad zu verbessern und die Oberfläche durch eine größere Rippenzahl mit der Folge eines geringen Rippenabstandes zu erhöhen.

Zur Lösung dieser Aufgabe führt die Lehre nach dem unabhägigen Anspruch; die Unteransprüche geben günstige Weiterbildungen an.

Erfindungsgemäß ist neben jeder eine Kühlrippe enthaltenden Einsatznut des Kühlkörpers eine freie Einsatznut angeordnet, die das freie Ende einer Kühlrippe eines gegenläufig aufgesetzten zweiten Kühlkörpers aufnimmt, in dessen Grundplatte bzw. Einsatznuten die Kühlrippen des ersten Kühlkörpers eingreifen. Dazu hat es sich als günstig erwiesen, eine an sich bekannte, eine der Einsatznuten flankierende Bodenrippe der Grundplatte mit ihrer Außenseite eine Seitenwand einer trichterförmigen Einsatznut für das freie Ende einer der gegenläufigen Kühlrippen des anderen Kühlkörpers bilden zu lassen. Diese Außenseite der Bodenrippe weist als Begrenzung der trichterförmigen Einsatznut eine Pultfläche mit anschließend in einem spitzen Winkel zur Ebene des Nutentiefsten geneigten Seitenfläche auf.

Nach einem weiteren Merkmal der Erfindung verläuft das Nutentiefste der trichterförmigen Einsatznut in Abstand zur benachbarten Einsatznut -- bevorzugt rechteckigen Querschnittes -- geringerer Tiefe, d.h. jene trichterförmige Einsatznut ist tiefer in die Grundplatte eingeformt.

Das erfindungsgemäß von einem Paar von Endstegen mit Zwischenraum gebildete freie Ende der Kühlrippe wird in jene trichterförmige Einsatznut eingeschoben, wobei jene Endstege begrenzt federn.

Im Rahmen der Erfindung liegt, daß die Kühlrippe durch mehrere Querstege in mehrere Strömungskanäle unterteilt ist sowie der hydraulische Durchmesser jedes der Strömungskanäle die vierfache lichte Fläche dividiert durch den Umfang bzw. die Kanaloberfläche ist - und damit etwa gleich dem hydraulischen Durchmesser eines zwischen den Kühlrippen verlaufenden Spaltkanals.

Die Oberfläche des Strömungskanals kann durch Parallelleisten vergrößert werden, welche an die den Strömungskanal begrenzenden Innenflächen angeformt sind. Zudem können die Parallelleisten der einen Rippenwand zu denen der anderen Rippenwand höhenversetzt sein.

Der aus dem Stand der Technik bekannte Kühlkörper ist beidseits seiner Grundplatte mit zu den Kühlrippen etwa parallel aufragenden Flankenwänden versehen, die der Länge der Kühlrippen entsprechen. Erfindungsgemäß ergänzen sich die Gehäuse der beiden aneinandergefügten Kühlkörper', wozu ein Kopfende einer Flankenwand wenigstens eine zu den Kühlrippen etwa parallele Kopfnut aufweist, in welche eine an das Kopfende des gegenläufig aufgesetzten Kühlkörpers angeformte Feder einsetzbar ist.

In diesem Falle sind die Flankenwände etwa von der halben Länge der Kühlrippen.

Da die Wärmequellen beiden Grundplatten anliegen, ist für den Rippenwirkungsgrad nur die halbe Länge der Kühl- oder Hohlrippen maßgebend. Durch den damit erheblich verbesserten Rippenwirkungsgrad und die große Oberfläche je Volumeneinheit wird eine Kühleinheit mit sehr hoher Kühlleistung erreicht.

Weitere Vorteile, Merkmale und Einzelheiten der Erfindung ergeben sich aus der nachfolgenden Beschreibung eines bevorzugten Ausführungsbeispieles sowie anhand der Zeichnung; diese zeigt in
- Fig. 1:: die Frontansicht einer Hochleistungskühleinheit aus zwei Kühlkörpern mit Kühlrippen in einem Gehäuse;
- Fig. 2:: eine einzelne Kühlrippe des Kühlkörpers;
- Fig. 3:: zwei vergrößerte Abschnitte der Kühlrippe aus Fig. 2;
- Fig. 4, 5:: vergrößerte Ausschnitte des Gehäuses entsprechend den Ausschnittfeldern IV, V der Fig. 1.

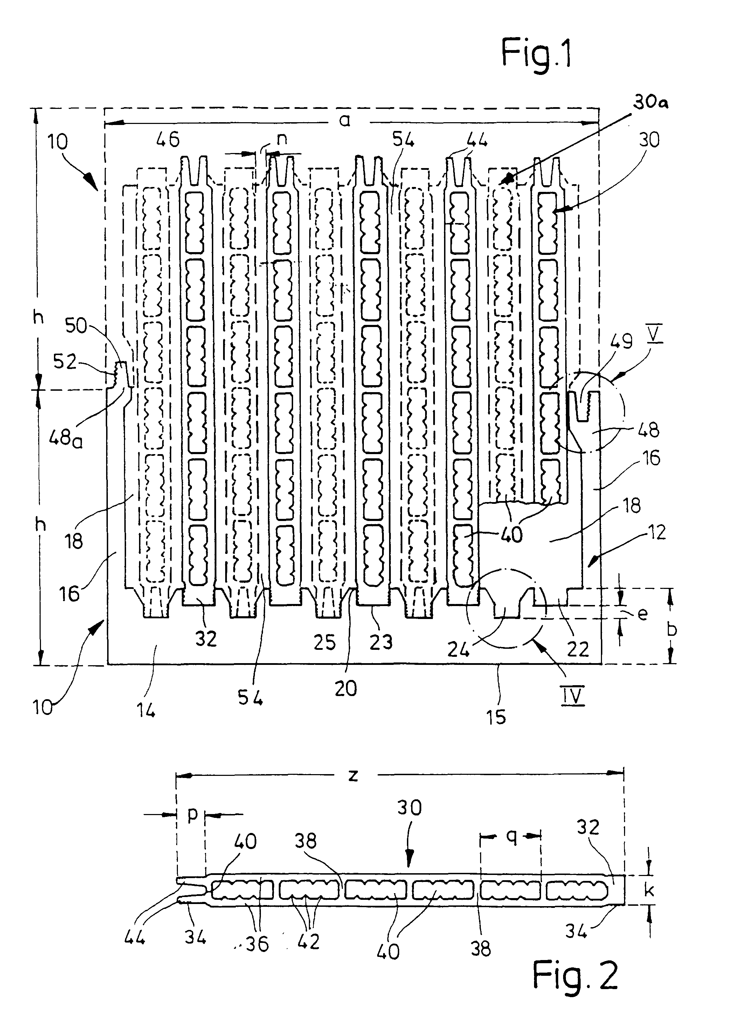

Eine Hochleistungskühleinheit aus Leichtmetall --insbesondere aus AlMgSiO.5 F 22 -- für in der Zeichnung aus Gründen der Übersichtlichkeit nicht weiter dargestellte Halbleiterbauelemente weist gemäß Fig. 1 zwei Kühlkörper 10 mit jeweils einem Gehäuse 12 aus einer Grundplatte 14 der Breite a von hier 84 mm und einer Dicke b von beispielsweise 13 mm sowie beidseits an die Grundplatte 14 angeformten Flankenwänden 16 auf. Letztere bilden mit der Grundplatte 14 eine -- stranggepreßte -- Rechteckrinne. Die Höhe h dieser Rechteckrinne bzw. des Gehäuses 12 mißt im gewählten Beispiel 47,5 mm.

In die Grundplatte 14 sind zum Gehäuseinnenraum 18 hin offene -- durch Bodenrippen 20 voneinander getrennte --Einsatznuten 22, 24 eingeformt; letztere sind wechselweise von rechteckigem'und trichterartigem Nutquerschnitt, wobei das Tiefste 23 der rechteckigen Einsatznut 22 in Abstand e von 2 mm oberhalb des Tiefsten 25 der trichterartigen Einsatznut 24 verläuft.

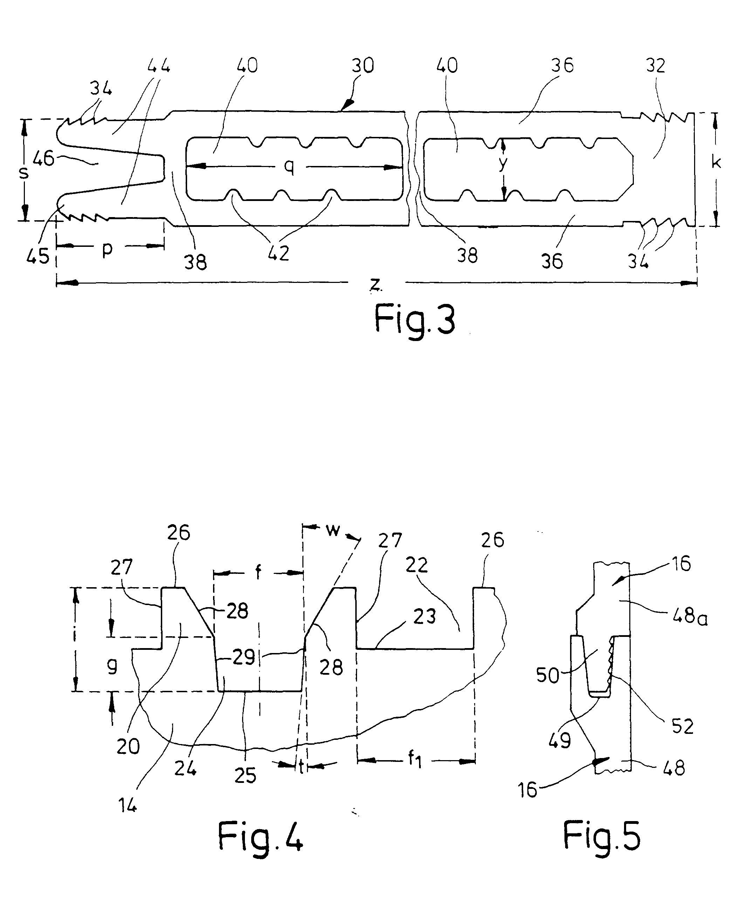

Wie vor allem Fig. 4 verdeutlicht, schließt an eine zur Unterfläche 15 der Grundplatte 14 parallele Firstfläche 26 jener Bodenrippe 20 einerseits eine zur Firstfläche 26 rechtwinkelige Seitenfläche 27 der rechteckigen Einsatznut 22 sowie anderseits eine -- in einem Winkel w von 30° geneigte Pultfläche 28 an, die in eine -- zur nahezu parallelen erwähnten Seitenfläche 27 in einem Winkel t von 2° nutwärts geneigte -- andere Seitenwand 29 übergeht. Die Breite f der Einsatznut 24 an diesem Übergang beträgt 25 mm, die Höhe g der anschließenden Seitenflächen 29 hier 2,7 mm und die Gesamttiefe i der Einsatznut 24 entspricht jener Breite f.

In die in Abständen c ihrer Mittelachsen A von 15 mm vorgesehenen fünf Einsatznuten 22 rechteckigen Querschnittes -- der Breite f₁ von 5,7 mm -- wird jeweils eine Hohl- oder Kühlrippe 30 der Länge z von 76,6 mm mit einem den Nutenquerschnitt ausfüllenden Kupplungssockel 32 der Breite k von 5,5 mm eingesetzt; aus dessen Seitenflächen sind des besseren Sitzes halber Längsleisten 34 sägezahnartigen Querschnitts herausgeformt. Vom Kupplungssockel 32 gehen zwei zur Mittelachse M parallele Rippenwände 36 aus, die in lichten Abständen q durch sechs Querstege 38 verbunden sind; diese begrenzen Profil- oder Strömungskanäle 40 der Breite y von 3 mm. In deren Querschnitt ragen aus den Rippenwänden 36 herausgeformte Parallelleisten 42 ein; die gegenüberliegenden Parallelleisten 42 sind jeweils versetzt angeordnet, wie beispielhaft Fig. 3 wiedergibt.

An der dem Kupplungssockel 32 fernliegenden Schmalseite endet die Hohl- oder Kühlrippe 30 mit einem Paar von parallelen Endstegen 44, die ihrerseits an den Außenflächen mehrere parallele Längsleisten 34 anbieten. Die Endstege 44 begrenzen einen sich endwärts erweiternden Zwischenraum 46 und ihre Außenflächen bestimmen an den gerundeten Spitzen 45 einen Querabstand s von 4, 4 mm.

Die Grundplatte 14 und die Kühlrippen 30 werden getrennt hergestellt und zwar jeweils auf dem Wege des Strangpressens als Leichtmetallprofile. Dann werden die --hier fünf -- Kühlrippen 30 in den Einsatznuten 32 der Grundplatte 14 zueinander parallel fomschlüssig festgelegt. So wird zunächst ein einteiliger Kühlkörper 10 geschaffen, der zwischen den einzelnen eingepreßten Kühlrippen 30 noch jene Einsatznuten 24 trichterförmigen Querschnitts enthält.

In einem querschnittlich breiteren Kopfende 48 der einen Flankenwand 16 des Gehäuses 12 ist eine Kopfnut 49 vorgesehen, am Kopfende 48ₐ der anderen Flankenwand 16 eine Feder 50 mit sägezahnförmig geriffelter Seitenfläche 52.

Zwei gleichartig ausgeführte Kühlkörper 10 der beschriebenen Art werden durch Wenden des einen Kühlkörpers 10 ineinander zur Hochleistungskühleinheit verschachtelt. Hierbei greifen die Paare der Endstege 44 am freien Ende der Kühlrippen 30 in die trichterförmigen Einsatznuten 24 des jeweils anderen Kühlkörpers 10 ein. Lediglich der besseren Übersicht halber sind in Fig. 1 die Kühlrippen des von oben her aufgesetzten Kühlkörpers 10 mit 30ₐ bezeichnet, ihre Mittelachsen mit M₁. Der Abstand c₁ zwischen den Mittelachsen M und M₁ beträgt 7,5 mm.

Da der Querabstand s der Endstege 44 größer ist als die Breite f am etwa rechteckigen Teil der trichterförmigen Einsatznut 24, werden beide Teile aufgrund der Federwirkung der Endstege 44 beim Zusammenfügen mittels einer -- auf die Grundplatten 14 beider Kühlkörper 10 aufgebrachten --Druckkraft verspannt. Auf gleiche Art greifen die Federn 50 der Flankenwände 16 in die Kopfnuten 49 der zugeordneten anderen Flankenwände 16 ein.

Diese Ausgestaltung der Hochleistungskühleinheit erlaubt eine sehr geringe Spaltweite n zwischen den Kühlrippen 30 und 30ₐ, die kleiner sein kann als die preßtechnisch mögliche lichte Weite k der Kühlrippe 30, 30ₐ. Um unterschiedliche hydraulische Durchmesser mit ungünstigen Strömungsverhältnissen zu vermeiden, ist -- wie erörtert --jede Kühlrippe 30, 30ₐ durch die Querstege 38 in eine Vielzahl von Profil- oder Strömungskanälen 40 so unterteilt, daß der hydraulische Durchmesser des einzelnen Strömungskanals 40 mit- der vierfachen lichten Fläche dividiert durch den Umfang in etwa gleich ist dem hydraulischen Durchmesser aus 2-fach lichter Spaltweite n des zwischen den Kühlrippen 30 und 30ₐ verlaufenden Spaltkanals 54. Zur Erhöhung des Umfanges bzw. der Oberfläche der Strömungskanäle 40 in der Kühl- oder Hohlrippe 30, 30ₐ sind an deren Innenwände -- versetzt zueinander -- die erwähnten Parallelleisten 42 angeformt; dadurch wird für gleiche Druckverhältnisse und gleichmäßigen Luftdurchsatz gesorgt.

## Patentansprüche

1. Hochleistungskühleinheit für Halbleiterbauelemente od. dergl. Geräte bestehend aus zwei gleichartig ausgeführten Kühlkörpern (10), insbesondere aus stranggepresstem Aluminium oder anderem Leichtmetall, jeder kühlkörper mit in Abstand zueinander an eine Grundplatte (14) angeschlossenen und davon aufragenden Kühlrippen (30), die jeweils als Hohlprofil mit zwei zueinander parallelen Rippenwänden (36) und diese verbindenden Querstegen (38) ausgebildet sind, wobei durch die Rippenwände (36) zwischen zwei benachbarten Querstegen (38) jeweils ein Strömungskanal (40) gebildet wird, und die Kühlrippen (30) einen Kupplungssockel (32) aufweisen und die Kühlrippen (30) mit ihrem Kupplungssockel (32) in von Bodenrippen (20) flankierten Einsatznuten (22) od. dergl. Ausnehmungen der Grundplatte (14) festliegen,
**dadurch gekennzeichnet, dass**
neben jeder eine Kühlrippe (30) enthaltenden Einsatznut (22) des ersten Kühlkörpers (10) in der Grundplatte (14) eine freie Einsatznut (24) angeordnet ist, die das freie Ende einer gegenläufigen Kühlrippe (30a) des zweiten Kühlkörpers (10) aufnimmt, in dessen Grundplatte die freien Enden der Kühlrippen (30) des ersten Kühlkörpers (10) eingreifen, und die freien Enden der Kühlrippen (30, 30a) jeweils von einem Paar von beidseits eines Zwischenraumes (46) verlaufender Endstege (44) gebildet ist, welche in die freie Einsatznut (24) des gegenläufigen, zweiten Kühlkörpers (10) eingeschoben sind.

2. Hochleistungskühleinheit nach Anspruch 1, **dadurch gekennzeichnet, dass** die Bodenrippe (20) in der Grundplatte (14) des Kühlkörpers (10) mit ihrer Aussenseite eine Seitenwand (28, 29) einer trichterförmigen Einsatznut (24) für das freie Ende einer gegenläufigen Kühlrippe (30a) des zweiten Kühlkörpers (10) bildet.

3. Hochleistungskühleinheit nach Anspruch 2, **dadurch gekennzeichnet, dass** die Aussenseite der Bodenrippe (20) des Kühlkörpers (10) als Begrenzung der trichterförmigen Einsatznut (24) eine Pultfläche (28) mit anschliessend in einem spitzen Winkel (t) zur Ebene des Nutentiefsten (25) geneigten Seitenfläche (29) aufweist.

4. Hochleistungskühleinheit nach einem der Ansprüche 2 bis 3, **dadurch gekennzeichnet, dass** das Nutentiefste (25) der trichterförmigen Einsatznut (24) in Abstand (e) zur benachbarten Einsatznut (22) bevorzugt rechteckigen Querschnittes und geringerer Nutentiefe verläuft.

5. Hochleistungskühleinheit nach einem der Ansprüche 1 bis 4, **dadurch gekennzeichnet, dass** die Kühlrippen (30, 30a) der Kühlkörper (10) durch mehrere Querstege (38) in mehrere Strömungskanäle (40) unterteilt sind, wobei der hydraulische Durchmesser jedes der Strömungskanäle etwa die vierfache lichte Fläche dividiert durch den Umfang ist.

6. Hochleistungskühleinheit nach Anspruch 5, **dadurch gekennzeichnet, dass** der hydraulische Durchmesser des Strömungskanals (40) etwa gleich dem hydraulischen Durchmesser eines zwischen den Kühlrippen (30, 30a) verlaufenden Spaltkanals (54) ist.

7. Hochleistungskühleinheit nach einem der Ansprüche 1 bis 6, **dadurch gekennzeichnet, dass** die Weite (y) des Strömungskanals (40) grösser ist als die lichte Spaltweite (n) zwischen zwei Kühlrippen (30, 30a).

8. Hochleistungskühleinheit nach einem der Ansprüche 1 bis 7, **dadurch gekennzeichnet, dass** an die den Strömungskanal (40) begrenzenden Innenflächen der Rippenwände(36) Parallelleisten (42) angeformt sind.

9. Hochleistungskühleinheit nach Anspruch 8, **dadurch gekennzeichnet, dass** die Parallelleisten (42) der einen Rippenwand (36) zu denen der anderen Rippenwand höhenversetzt sind.

10. Hochleistungskühleinheit nach einem der Ansprüche 1 bis 9, **dadurch gekennzeichnet, dass** die Kühlkörper (10) von ihrer Grundplatte (14) beidseits der Kühlrippen (30, 30a) und zu diesen etwa parallel aufragende Flankenwände (16) aufweisen, und dass ein Kopfende (48) der einen Flankenwand (16) wenigstens eine zu den Kühlrippen (30, 30a) etwa parallele Kopfnut (49) aufweist, in welche eine an das Kopfende (48a) der zugeordneten Flankenwand des gegenläufig aufgesetzten Kühlkörpers (10) angeformte Feder (50) eingesetzt ist.

## Claims

1. High-efficiency cooling unit for semiconductor devices or the like, consisting of two heat sinks (10) of identical design, in particular made from extruded aluminium or another light metal, each heat sink comprising cooling fins (30) connected at a distance from one another to a base plate (14) and projecting therefrom, each in the form of a hollow section with two parallel fin walls (36) and crossbars (38) connecting them, respective flow channels (40) being formed between two adjacent crossbars (38) by the fin walls (36), the cooling fins (30) having coupling bases (32) and the cooling fins (30) being fixed via their coupling bases (32) in insertion slots (22) or similar recesses in the base plate (14) flanked by bottom fins (20), **characterised in that** a free insertion slot (24) is arranged alongside each insertion slot (22) of the first heat sink (10) in the base plate (14) containing a cooling fin (30) and receives the free end of an opposite cooling fin (30a) of the second heat sink (10), in the base plate of which the free ends of the cooling fins (30) of the first heat sink (10) engage, and the free ends of the cooling fins (30, 30a) are each formed by a pair of end bars (44) extending on either side of an intermediate space (46) and inserted into the free insertion slot (24) of the opposite second heat sink (10).

2. High-efficiency cooling unit according to claim 1, **characterised in that** the outer face of the bottom fin (20) in the base plate (14) of the heat sink (10) forms a side wall (28, 29) of a funnel-shaped insertion slot (24) for the free end of an opposite cooling fin (30a) of the second heat sink (10).

3. High-efficiency cooling unit according to claim 2, **characterised in that** the outer face of the bottom fin (20) of the heat sink (10) has a sloping surface (28) serving as the boundary of the funnel-shaped insertion slot (24), followed by a side surface (29) inclined at an acute angle (t) relative to the plane of the bottom (25) of the slot.

4. High-efficiency cooling unit according to one of claims 2 to 3, **characterised in that** the bottom (25) of the funnel-shaped insertion slot (24) extends at a distance (e) from the adjacent insertion slot (22) preferably having a rectangular cross section and a smaller slot depth.

5. High-efficiency cooling unit according to one of claims 1 to 4, **characterised in that** the cooling fins (30, 30a) of the heat sinks (10) are divided into a plurality of flow channels (40) by a plurality of crossbars (38), the hydraulic diameter of each of the flow channels being approximately four times the clear surface area divided by the circumference.

6. High-efficiency cooling unit according to claim 5, **characterised in that** the hydraulic diameter of the flow channel (40) is approximately equal to the hydraulic diameter of a gap channel (54) extending between the cooling fins (30, 30a).

7. High-efficiency cooling unit according to one of claims 1 to 6, **characterised in that** the width (y) of the flow channel (40) is larger than the clear gap width (n) between two cooling fins (30, 30a).

8. High-efficiency cooling unit according to one of claims 1 to 7, **characterised in that** parallel strips (42) are moulded on to the inner surfaces of the fin walls (36) delimiting the flow channel (40).

9. High-efficiency cooling unit according to claim 8, **characterised in that** the parallel strips (42) of one fin wall (36) are vertically offset relative to the other fin wall.

10. High-efficiency cooling unit according to one of claims 1 to 9, **characterised in that** the heat sinks (10) have flanking walls (16) projecting from their base plates (14) on either side of the cooling fins (30, 30a) approximately parallel thereto and that a top end (48) of one flanking wall (16) has at least one top slot (49) approximately parallel to the cooling fins (30, 30a) into which a spring (50) moulded on to the top end (48a) of the associated flanking wall of the opposite heat sink (10) is inserted.

## Revendications

1. Unité de refroidissement de haute puissance pour des dispositifs semi-conducteurs ou dispositifs similaires comportant deux dissipateurs de chaleur (10) réalisés de manière similaire, en particulier en aluminium extrudé ou un autre métal léger, chaque dissipateur de chaleur comportant des ailettes de refroidissement (30) écartées l'une de l'autre raccordées à une plaque de base (14) et dépassant de celle-ci, qui sont formées respectivement sous la forme de profilé creux avec deux parois d'ailettes (36) parallèles entre elles et d'entretoises (38) reliant celles-ci, un canal d'écoulement (40) étant chaque fois formé par les parois d'ailettes (36) entre deux entretoises (38) adjacentes et les ailettes de refroidissement (30) présentant un socle d'accouplement (32) et les ailettes de refroidissement (30) étant fixées par leur socle d'accouplement (32) dans des rainures de logement (22) ou renfoncements similaires flanquées de nervures de plancher (20) de la plaque de base (14),
**caractérisée en ce que**,
à côté de chaque rainure de logement (22) contenant une ailette de refroidissement (30) du premier dissipateur de chaleur (10), une rainure de logement (24) libre est disposée dans la plaque de base (14), laquelle accueille l'extrémité libre de l'ailette de refroidissement opposée (30a) du deuxième dissipateur de chaleur (10), dans la plaque de base duquel les extrémités libres des ailettes de refroidissement (30) du premier dissipateur de chaleur (10) font prise, et les extrémités libres des ailettes de refroidissement (30, 30a) sont formées respectivement par une paire de nervures d'extrémité (44) s'étendant des deux côtés d'un espace intermédiaire (46), qui sont insérées dans la rainure de logement libre (24) du dissipateur de chaleur (10) opposé.

2. Unité de refroidissement de haute puissance suivant la revendication 1, **caractérisée en ce que** la nervuré de plancher (20) forme avec sa face extérieure dans la plaque de base (14) du dissipateur de chaleur (10) une paroi latérale (28, 29) d'une rainure de logement (24) en forme d'entonnoir pour l'extrémité libre d'une ailette de refroidissement (30a) opposée du deuxième dissipateur de chaleur (10).

3. Unité de refroidissement de haute puissance suivant la revendication 2, **caractérisée en ce que** la face extérieure de la nervure de plancher (20) du dissipateur de chaleur (10) présente comme limitation de la rainure de logement (24) en forme d'entonnoir une surface en pente (28) raccordée à une surface latérale (29) faisant un angle aigu (t) avec le plan de la surface latérale de la partie la plus profonde de la rainure (25).

4. Unité de refroidissement de haute puissance suivant l'une des revendications 2 à 3, **caractérisée en ce que** la partie la plus profonde (25) de la rainure de logement (24) en forme d'entonnoir s'étend à distance (e) de la rainure de logement (22) adjacente de section de préférence rectangulaire et de plus faible profondeur.

5. Unité de refroidissement de haute puissance suivant l'une des revendications 1 à 4, **caractérisée en ce que** les ailettes de refroidissement (30, 30a) des dissipateurs de chaleur (10) sont divisés par plusieurs entretoises (38) en plusieurs canaux d'écoulement (40), le diamètre hydraulique de chacun des canaux d'écoulement étant environ égal au quadruple de la section libre divisé par le périmètre.

6. Unité de refroidissement de haute puissance suivant la revendication 5, **caractérisée en ce que** le diamètre hydraulique du canal d'écoulement (40) est environ égal au diamètre hydraulique d'un canal de séparation (54) s'étendant entre les ailettes de refroidissement (30, 30a).

7. Unité de refroidissement de haute puissance suivant l'une des revendications 1 à 6, **caractérisée en ce que** la largeur (y) du canal d'écoulement (40) est plus grande que la largeur d'interstice libre (n) entre deux ailettes de refroidissement (30, 30a).

8. Unité de refroidissement de haute puissance suivant l'une des revendications 1 à 7, **caractérisée en ce que** des listels parallèles (42) sont formés sur les surfaces intérieures des parois d'ailettes (36) limitant le canal d'écoulement (40).

9. Unité de refroidissement de haute puissance suivant la revendication 8, **caractérisée en ce que** les listels parallèles (42) d'une paroi d'ailette (36) sont décalés en hauteur par rapport à ceux de l'autre paroi d'ailette.

10. Unité de refroidissement de haute puissance suivant l'une des revendications 1 à 9, **caractérisée en ce que** les dissipateurs de chaleur (10) présentent des parois latérales (16) dépassant de leur plaque de base (14) des deux côtés des ailettes de refroidissement (30, 30a) et s'étendant autant dire parallèlement à celles-ci et en ce qu'une extrémité de tête (48) d'une paroi latérale (16) présente au moins une rainure de tête (49) autant dire parallèle aux ailettes de refroidissement (30, 30a), dans laquelle peut se placer un ressort (50) formé à l'extrémité de tête (48a) de la paroi latérale correspondante du dissipateur de chaleur (10) disposé en opposition.
